# EUROPEAN PATENT APPLICATION

(11) **EP 2 899 744 A1**
(43) Date of publication of application: **29.07.2015**
(21) Application number: 14152568.3
(22) Date of filing: 24.01.2014
(51) Int. Cl.: H01J 37/26, H01J 37/295, H01J 37/305

(54) **Method for preparing and analyzing an object as well as particle beam device for performing the method**

(71) Applicant: Carl Zeiss Microscopy GmbH, 07745 Jena (DE)
(72) Inventor: Pavia, Giuseppe, 73433 Aalen (DE)
(74) Representative: Tongbhoyai, Martin

(57) **Abstract**

The present invention relates to a method for preparing and analyzing an object (16, 36) comprising a region of interest to be analyzed. The method comprises removing material from a first surface of the object (16) using a second particle beam and monitoring the first surface of the object (16) using a first particle beam and using a second detector, wherein a second surface of the object (16) is generated when the material is removed from the first surface of the object (16), removing material from the second surface of the object (16) using the second particle beam and monitoring the step of removing the material from the object (16) using the first particle beam and using the second detector, wherein the step of removing the material generates a first side (39) of the region of interest and a second side of the region of interest (33), wherein the region of interest (33) to be analyzed is arranged between the first side (39) and the second side (40), guiding the first particle beam to the first side (39) of the region of interest, detecting first charged particles of the first particle beam being transmitted through the region of interest using a first detector (EBSD detector 1000), generating detection signals using the detected first charged particles and acquiring at least one Kikuchi diffraction pattern of the region of interest, and analyzing the region of interest using the diffraction pattern

## Description

The present invention relates to a method for preparing and analyzing an object comprising a region of interest to be analyzed. The present invention also relates to a particle beam device for performing the method (i.e. implementing the method).

Particle beam devices, such as electron beam devices, have been used for some time for studying objects which are also often identified as specimens or samples. In particular, scanning electron microscopes (also known as SEM) and transmission electron microscopes (also known as TEM) are known.

In an SEM, an electron beam generated using a beam generator is focused through an objective lens on the object to be analyzed. Using a deflection device, the electron beam (also referred to as the primary electron beam hereafter) is scanned over the surface of the object. The electrons of the primary electron beam interact with the object. As a result of the interaction, in particular electrons are emitted from the object (so-called secondary electrons) or electrons of the primary electron beam are scattered back (so-called backscattered electrons). Secondary and backscattered electrons form the so-called secondary beam and are detected using a detector. The detector signal thus generated is used for image generation.

In the case of a TEM, likewise, a primary electron beam is generated using a beam generator and is guided to an object to be analyzed using a beam guidance system. The primary electron beam passes through the object to be analyzed. When the primary electron beam passes through the object to be analyzed, the electrons in the primary electron beam interact with the material of the object to be analyzed. The electrons passing through the object to be analyzed are imaged onto a phosphor screen using a system comprising an objective and a projection lens, or are detected by a position-resolving detector (for example a camera). In the scanning mode of a TEM, as in an SEM, the primary electron beam of the TEM is focused on the object to be analyzed, and is guided in a raster shape over the object to be analyzed, using a deflection device. The transmitted unscattered electrons as well as the transmitted (highly) scattered electrons are analyzed by different detectors generating detector signals. The generated detector signals may be used for generating an image of the analyzed object. A TEM such as this is generally referred to as an STEM.

Equipping a SEM with an ion beam column is also known. Ions are generated using an ion beam generator situated in the ion beam column, which are used for the preparation of objects (such as polishing an object or applying material to an object) or also for imaging.

A further known device using a particle beam for the preparation of an object in a particle beam device is described hereafter. Using this further known device, a second specimen is extracted from a first specimen, which is situated in a sample chamber on a specimen table, and fastened to a specimen holder, which is also situated on the specimen table. The specimen holder is discharged from the sample chamber for further study of the second specimen. This is disadvantageous for many applications, because on one hand, the discharge of the specimen holder requires a long time and, on the other hand, there is a risk of the second specimen being contaminated or being damaged by this way of preparation.

Furthermore, a device and a method for specimen preparation having the following features and method steps, respectively, are known from the related art. An object is situated on a specimen table (also known as specimen stage) in a sample chamber in a particle beam device. In a first position of the specimen table, a piece is cut out of the object using an ion beam and this cut out piece is fastened to a specimen holder which is situated on the specimen table. The specimen table is brought by movement into a second position, in which an electron beam is focused on this piece for further study. Electrons transmitted through this piece are detected using a detector.

Reference is made to DE 103 51 276 A1, US 6,963,068, EP 0 927 880 A1 and DE 10 2007 026 847 A1 in regard to the above-mentioned related art.

Electron backscatter diffraction (also known as EBSD) is a technique used to analyze the crystallographic orientation of materials. It is known to use EBSD in an SEM having an EBSD detector. The EBSD detector may comprise a CCD chip. The EBSD detector detects electrons backscattered from the object and generates detection signals. Based on the detection signals, an electron backscatter diffraction pattern (also known as EBSP) is generated. The EBSP comprises information about Kikuchi bands corresponding to lattice diffraction planes of an object to be analyzed.

A further technique for analyzing an object is known as transmission Kikuchi diffraction (also known as TKD). When using TKD, an electron beam is guided to an object which is thin enough to be transparent for electrons of the electron beam. In other words, electrons of the electron beam may transmit through the object. For example, the object is a foil. The object is positioned approximately horizontal with respect to the sample chamber. Alternatively, the object is slightly tilted away from the EBSD detector by an angle of up to 20° or up to 30°. The scattered and transmitted electrons of the electron beam emerging from a bottom side of the object are detected using the EBSD detector. The EBSD detector is positioned off-axis with respect to the optical axis of the electron beam guided to the object. In particular, the EBSD detector is positioned below the object at a position which is normally used for standard EBSD. The EBSD detector generates detector signals used for acquiring and recording diffraction patterns of the object, the diffraction patterns being projected from the bottom side of the object to the EBSD detector.

The present invention is based on the object of providing a method and a particle beam device for performing the method for preparing an object which can be analyzed in-situ using TKD.

According to the present invention, this object is achieved by a method having the features of claim 1 or claim 11. A computer program product with respect to the method is given by the features of claim 12. A particle beam device for performing the method is given by the features of claim 13. Exemplary embodiments and further features of the present invention are apparent from the further claims, the description, and/or the appended figures.

The method according to the invention is used for preparing and analyzing an object comprising a region of interest to be analyzed. The method is carried out using a particle beam device. The particle beam device comprises at least one first particle beam column having a first optical axis and at least one second particle beam column having a second optical axis.

The first particle beam column comprises at least one first particle beam generator for generating a first particle beam having first charged particles and at least one first objective lens for focusing the first particle beam onto the object. For example, the first particle beam column is an electron beam column and the first particle beam generator generates a first particle beam in the form of an electron beam. Alternatively, the first particle beam column is an ion beam column and the first particle beam generator generates a first particle beam in the form of an ion beam. The ion beam comprises, for example, Gallium ions, Neon ions and/or Argon ions. However, the invention is not restricted to the use of the aforementioned ions. Instead, any kind of ions may be used.

The second particle beam column comprises at least one second particle beam generator for generating a second particle beam having second charged particles and at least one second objective lens for focusing the second particle beam onto the object. For example, the second particle beam column is an ion beam column and the second particle beam generator generates a second particle beam in the form of an ion beam. The ion beam comprises, for example, Gallium ions, Neon ions and/or Argon ions. However, the invention is not restricted to the use of the aforementioned ions. Instead, any kind of ions may be used.

The object is arranged on a carrier element of the particle beam device. The carrier element is movable in at least three spatial directions oriented perpendicular to one another. Moreover, the carrier element is rotatable around a first rotation axis and around a second rotation axis being oriented perpendicular to the first rotation axis. The second rotation axis may be oriented parallel to the first optical axis or may correspond to the first optical axis.

The particle beam device comprises detectors for detecting particles. On one hand, the particle beam device comprises a first detector for detecting first charged particles being transmitted through the object. As explained further below, the detected first charged particles are used for generating diffraction patterns. On the other hand, the particle beam device comprises a second detector for detecting interaction particles and/or interaction radiation generated when the first particle beam impinges on the object. In particular, particles (for example electrons) are emitted from the object (so-called secondary particles) or particles (for example electrons) of the first particle beam are scattered back (so-called backscattered particles). Secondary particles and/or backscattered particles are detected. Detector signals generated by the second detector are used for generation of an image which is, for example, displayed on a screen and/or monitor.

The method according to the invention comprises a step of moving the carrier element to a first position such that the second optical axis is parallel or basically parallel to a first surface of the object. The difference of orientation of the second optical axis and the first surface of the object may be about 2° or about 4°. If the second optical axis is parallel or basically parallel to the first surface of the object, the second particle beam impinges on the first surface with grazing incidence.

Furthermore, the method according to the invention comprises a step of removing material from the first surface of the object using the second particle beam. A second surface of the object is generated when the material is removed from the first surface of the object. The removal of the material and/or the generating of the second surface is/are monitored using the first particle beam and the second detector, as explained above.

Additionally, the method according to the invention comprises the step of moving the carrier element to a second position. The second optical axis is perpendicular to the second surface of the object in this second position. When the carrier element is in the second position, a further step of the method according to the invention is carried out, namely removing material of the object from the second surface of the object using the second particle beam. The step of removing the material of the object is monitored using the first particle beam and the second detector. When removing the material, a first side of the region of interest and a second side of the region of interest are generated, the first side being arranged opposite the second side. The region of interest is arranged between the first side and the second side. The before mentioned step can also be phrased as follows. When the carrier element is in the second position, a lamella is generated by removing the material from the second surface. The lamella is or comprises the region of interest. The lamella may be situated anywhere on the second surface, for example in the middle of the second surface. The material around the lamella is removed so that the lamella is accessible from several directions, for example from two sides of the lamella, wherein the two sides are the first side and the second side.

The method according to the invention also comprises a step of moving the carrier element to a third position so that the first optical axis and the first side of the region of interest are oriented at an angle to one another, wherein the angle is in the range of 60° to 90°. The boundaries of the range are included in this range. After having reached the third position, the first particle beam is guided to the first side of the region of interest. First charged particles entering the region of interest on the first side and being transmitted through the region of interest are detected using the first detector. The first detector generates detection signals using the detected first charged particles. At least one diffraction pattern or several diffraction patterns of the region of interest are acquired, using the detection signals. The region of interest is then analyzed using the diffraction pattern or the diffraction patterns. The detection signals are used, for example, to generate a diffraction pattern projected from the second side of the region of interest being oriented in the direction of the first detector. In one embodiment of the invention, the first detector is a detector normally used in EBSD as explained above. For example, the first detector comprises a CCD chip or a scintillator connected to a CCD chip with a detection area of about 20 mm x 20 mm or 30 mm x 30 mm.

The method according to the invention provides for a simple preparation of a region of interest to be analyzed combined with an analysis using TKD. A sample (that is the object) thin enough for transmission of charged particles is generated and is analyzed without discharging the sample from the sample chamber for introducing the sample into a further device. Instead, sample preparation and the analysis of the sample are carried out using a single particle beam device. The sample preparation is carried out "in-situ". Therefore, the risk of damaging the sample when discharging the sample out of the particle beam device is lowered. The invention ensures a minimum damage of the sample due to contamination and, therefore, damage of the crystalline structure of the sample.

In an embodiment of the method according to the invention, it is additionally or alternatively provided that the method further comprises acquiring a crystalline data value depending on a crystalline structure of the region of interest. The crystalline data value is displayed on the screen or the monitor. Furthermore, an image of the region of interest is displayed on the screen or the monitor. For example, the image is obtained by detecting interaction particles and/or interaction radiation as mentioned above using the second detector. Furthermore, crystalline data values and/or topographical data values of the region of interest may be superimposed or combined with the data of the image obtained using the second detector.

In an embodiment of the method according to the invention, it is additionally or alternatively provided that the method further comprises identifying the region of interest using the first particle beam. For example, an image of a surface of the object is generated using the first particle beam. It is possible to identify the region of interest using the generated image. However, the invention is not restricted to the aforementioned way of identifying the region of interest. Instead, any method of identifying the region of interest can be used, for example identifying using a photon beam. In particular, EDX or a light beam, for example a laser beam may be used.

In a further embodiment of the method according to the invention, it is additionally or alternatively provided that material of the object is removed, for example using mechanical polishing or using laser ablation. In particular, the removing is carried out until the first surface is at a distance of about 10 µm to 60 µm from the region of interest. The aforementioned removal of material can be performed in a different device than the particle beam device. After coarse removal of the material the object may be positioned on the carrier element. Alternatively, the aforementioned removal may be performed in the particle beam device, for example using the second particle beam.

In a further embodiment of the method according to the invention, it is additionally or alternatively provided that the first side of the region of interest and the second side of the region of interest are oriented parallel to one another and/or that the first side of the region of interest and the second side of the region of interest are oriented perpendicular to the second surface of the object. The step of removing material from the second surface comprises removing material so that a lamella having a first side wall and a second side wall is formed. The lamella may have a thickness of 40 nm to 300 nm or 70 nm to 100nm between the first side wall and second side wall. The lamella includes the region of interest. Because of its thickness of 40 nm to 300 nm or of 70 nm to 100 nm such lamella is especially suitable for TKD.

In an embodiment of the method according to the invention, it is additionally or alternatively provided that the step of removing material from the first surface of the object using the second particle beam comprises generating a U-shaped form on the first surface. In particular, the U-shaped form comprises a base limb and two side limbs extending from the base limb. In particular, the region of interest is arranged in the area of the base limb. For example, the base limb comprises the second surface.

In an embodiment of the invention, the first particle beam is an electron beam. It is additionally or alternatively provided that the step of monitoring the first surface of the object comprises using the electron beam and/or the step of monitoring the second surface of the object comprises using the electron beam. It is additionally or alternatively provided that the step of removing material from the first surface of the object comprises using the ion beam and/or the step of removing material of the object from the second surface comprises using the ion beam.

In a further embodiment of the invention, it is additionally or alternatively provided that the steps of moving the carrier element into the first position, the second position and/or the third position comprise specific movements. For example, the step of moving the carrier element to the first position comprises rotating the carrier element around the first rotation axis at an angle between 10° and 20° or between 12° and 18°. The aforementioned boundaries of the angle ranges are included in those ranges. For example, in one embodiment of the invention the carrier element is rotated around the first rotation axis at an angle of 10°, 12°, 18° or 20°. In a further embodiment of the invention, it is additionally or alternatively provided that the step of moving the carrier element to the second position comprises rotating the carrier element around the second rotation axis at an angle between 160° to 200° or between 170° and 180°, and the step of moving the carrier element also comprises rotating the carrier element around the first rotation axis at an angle between 10° and 20° or between 12° and 18°. Again, the aforementioned boundaries of the angle ranges are included in those ranges. For example, in one embodiment of the invention, the carrier element is rotated around the second rotation axis at an angle of 160°, 170°, 180° or 200° and/or the carrier element is rotated around the first rotation axis at an angle of 10°, 12°, 18° or 20°. In another embodiment of the invention, it is additionally or alternatively provided that the step of moving the carrier element to the third position comprises rotating the carrier element around the first rotation axis at an angle between 4° and 40° or at an angle between 6° and 36°. Again, the aforementioned boundaries of the angle ranges are included in those ranges. For example, in one embodiment of the invention the carrier element is rotated around the first rotation axis at an angle of 4°, 6°, 36° or 40°. As mentioned further below, in an embodiment of the invention, it is possible to move the carrier element in such a way that a surface normal to the first side wall and/or the second side wall of the lamella comprising the region of interest is arranged at an angle in the range of 0° to 30° relative to the first optical axis (of the first particle beam column). Again, the boundaries of this angle range are included in the range.

In a further embodiment of the invention, it is additionally or alternatively provided that the first particle beam column and the second particle beam column are arranged at an angle α to one another, with 0° ≤ α ≤ 90° or with 40° ≤ α ≤ 90°. For example, α is 54°. The carrier element comprises a receiving surface on which the object is arranged. When being in the second position, the receiving surface of carrier element is arranged at the angle α to the first optical axis.

In an embodiment of the invention, it is additionally or alternatively provided that the method according to the invention comprises the step of moving the first detector to a first position for detecting first charged particles being transmitted through the object. Additionally or alternatively it is provided that the method comprises the step of moving the first detector to a second position, the second position being for example at a distance of approximately 10 cm to 20 cm to the first position, when removing material from the first surface or the second surface of the object, in order to avoid damaging the first detector and/or to avoid re-sputtering of material removed from the object.

In an embodiment of the invention, it is additionally or alternatively provided that the method is carried out within a vacuum chamber of the particle beam device and wherein at least one of the steps or at least two of the steps according to the method are performed while maintaining the object within the vacuum chamber.

The invention also relates to a method for preparing and analyzing an object comprising a region of interest to be analyzed, wherein the method is carried out using a particle beam device, wherein the method comprises the following steps:
- moving a carrier element to a first position such that a second optical axis is parallel to a first surface of the object,
- removing material from a first surface of the object using a second particle beam and monitoring the first surface of the object using a first particle beam and using a second detector, wherein a second surface of the object is generated when the material is removed from the first surface of the object,
- moving the carrier element to a second position such that the second optical axis is perpendicular to the second surface of the object,
- removing material from the second surface of the object using the second particle beam and monitoring the step of removing the material from the object using the first particle beam and using the second detector,

wherein the step of removing the material generates a first side of the region of interest and a second side of the region of interest, wherein the first side is arranged opposite the second side and wherein the region of interest to be analyzed is arranged between the first side and the second side, moving the carrier element to a third position such that the first optical axis and the first side of the region of interest are oriented at an angle to one another, wherein the angle is in the range of 60° to 90°,
- guiding the first particle beam to the first side of the region of interest,
- detecting first charged particles of the first particle beam being transmitted through the region of interest using a first detector,
- generating detection signals using the detected first charged particles and acquiring at least one diffraction pattern of the region of interest, and
- analyzing the region of interest using the diffraction pattern.

The invention also relates to a computer program product which is loaded or is to be loaded into a processor of a particle beam device, for example a particle beam device as mentioned above and comprising at least one of the above mentioned features with respect to the particle beam device. The computer program product comprises software for controlling the particle beam device in such a way that the particle beam device performs a method with at least one of the above mentioned method steps or a combination of at least two of the above mentioned method steps.

The invention also relates to a particle beam device for preparing and analyzing an object comprising a region of interest. The particle beam device comprises at least one first particle beam column, wherein the first particle beam column comprises a first optical axis, at least one first particle beam generator for generating a first particle beam having first charged particles and at least one first objective lens for focusing the first particle beam onto the object. Moreover, the particle beam device comprises at least one second particle beam column, wherein the second particle beam column comprises a second optical axis, at least one second particle beam generator for generating a second particle beam having second charged particles and at least one second objective lens for focusing the second particle beam onto the object. The particle beam device also has at least one carrier element on which the object is to be arranged, wherein the carrier element is movable in at least three spatial directions oriented perpendicular to one another and wherein the carrier element is rotatable around a first rotation axis and around a second rotation axis being oriented perpendicular to the first rotation axis. The particle beam device also has a first detector for detecting first charged particles being transmitted through the object and a second detector for detecting interaction particles and/or interaction radiation being generated when the first particle beam impinges on the object. Moreover, the particle beam device comprises a control unit comprising a processor, wherein a computer program product as mentioned above is loaded into the processor.

Embodiments of the invention are now described using the appended figures, wherein
- Figure 1: shows a schematic illustration of an embodiment of a particle beam device according to the invention;
- Figure 2: shows a detailed illustration of the particle beam device shown in Figure 1;
- Figure 3: shows a first schematic view of a sample stage;
- Figure 4: shows a second schematic view of the sample stage of Figure 3;
- Figure 5: shows an illustration of a side view of an embodiment of a sample receptacle of the sample stage of Figure 3;
- Figure 6: shows method steps of an embodiment of a method according to the invention;
- Figure 7: shows a first schematic view of a sample comprising a region of interest to be analyzed;
- Figure 8: shows a second schematic view of the sample comprising a region of interest to be analyzed;
- Figure 9: shows the sample receptacle of the sample stage of Figure 5 in a first position;
- Figure 10: shows a third schematic view of the sample comprising a region of interest to be analyzed;
- Figure 11: shows a fourth schematic view of the sample comprising a region of interest to be analyzed;
- Figures 12 A-C: shows further schematic views of the sample receptacle of the sample stage of Figure 5 in different positions for analyzing the sample;
- Figure 13: shows a fifth schematic view of the sample in an analyzing position;
- Figure 14A: shows an illustration of a side view of a further embodiment of the sample receptacle of the sample stage;
- Figure 14B: shows a further schematic view of a sample comprising a region of interest to be analyzed;
- Figure 15: shows a further method step of an embodiment of a method according to the invention; and
- Figure 16: shows a schematic illustration of positions of a detector.

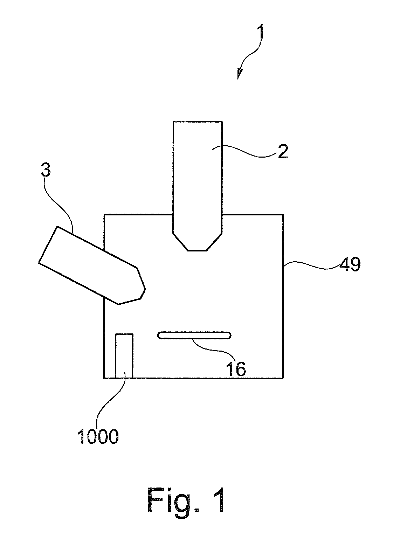

Figure **1** shows a schematic illustration of one embodiment of a particle beam device 1 according to the invention. The particle beam device 1 has a first charged particle beam column 2 in the form of an electron beam column and a second charged particle beam column 3 in the form of an ion beam column. The first charged particle beam column 2 and the second charged particle beam column 3 are arranged on a sample chamber 49, in which a sample 16 to be analyzed is arranged. It is explicitly noted that the invention is not restricted to the first charged particle beam column 2 being in the form of an electron beam column and the second charged particle beam column 3 being in the form of an ion beam column. In fact, the invention also provides for the first charged particle beam column 2 to be in the form of an ion beam column and for the second charged particle beam column 3 to be in the form of an electron beam column. A further embodiment of the invention provides for both the first charged particle beam column 2 and the second charged particle beam column 3 each to be in the form of an ion beam column or each to be in the form of an electron beam column. **Figure 1** also schematically shows an EBSD detector 1000, which will be described further below in more detail.

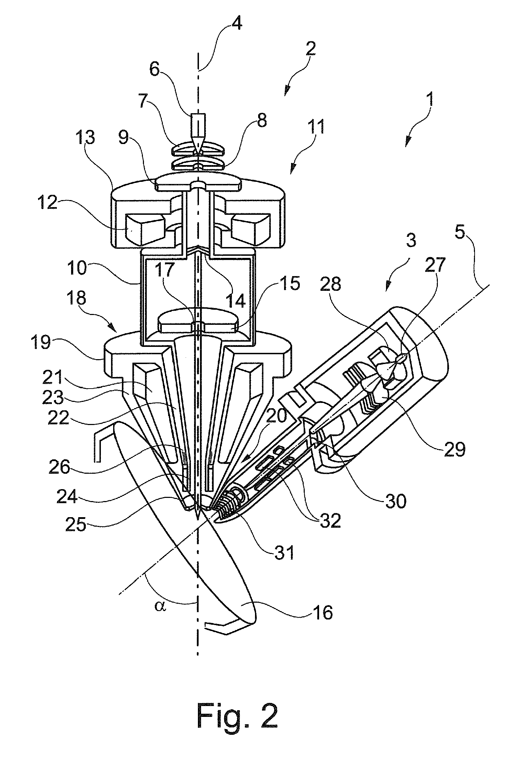

**Figure 2** shows a detailed illustration of the particle beam device 1 shown in **Figure 1****.** For clarity reasons, the sample chamber 49 is not illustrated. The first charged particle beam column 2 in the form of the electron beam column has a first optical axis 4. Furthermore, the second charged particle beam column 3 in the form of the ion beam column has a second optical axis 5.

The first charged particle beam column 2, in the form of the electron beam column, will now be described first. The first charged particle beam column 2 has a first beam generator 6, a first electrode 7, a second electrode 8 and a third electrode 9. By way of example, the first beam generator 6 is a thermal field emitter. The first electrode 7 has the function of a suppressor electrode, while the second electrode 8 has the function of an extractor electrode. The third electrode 9 is an anode, and at the same time forms one end of a beam guide tube 10. A first particle beam, namely a first charged particle beam, in the form of an electron beam is generated using the first beam generator 6. Electrons which emerge from the first beam generator 6 are accelerated to the anode potential, for example in the range from 1 kV to 30 kV, as a result of a potential difference between the first beam generator 6 and the third electrode 9. The first particle beam in the form of the electron beam passes through the beam guide tube 10, and is focused onto the sample 16 to be analyzed. This will be described in more detail further below.

The beam guide tube 10 passes through a collimator arrangement 11 which has a first annular coil 12 and a yoke 13. Seen in the direction of the sample 16, from the first beam generator 6, the collimator arrangement 11 is followed by a pinhole diaphragm 14 and a detector 15 with a central opening 17 arranged along the first optical axis 4 in the beam guide tube 10. The beam guide tube 10 then runs through a hole in a first objective lens 18. The first objective lens 18 is used for focusing the first particle beam onto the sample 16. For this purpose, the first objective lens 18 has a magnetic lens 19 and an electrostatic lens 20. The magnetic lens 19 is provided with a second annular coil 21, an inner pole piece 22 and an outer pole piece 23. The electrostatic lens 20 has an end 24 of the beam guide tube 10 and a terminating electrode 25. The end 24 of the beam guide tube 10 and the terminating electrode 25 form an electrostatic deceleration device. The end 24 of the beam guide tube 10, together with the beam guide tube 10, is at the anode potential, while the terminating electrode 25 and the sample 16 are at a potential which is lower than the anode potential. This allows the electrons in the first particle beam to be decelerated to a desired energy which is required for an examination of the sample 16, in particular for generating an image as explained further below. The first charged particle beam column 2 furthermore has a raster device 26, by means of which the first particle beam can be deflected and can be scanned in the form of a raster over the sample 16.

For imaging purposes, the detector 15, which is arranged in the beam guide tube 10, detects secondary electrons and/or back-scattered electrons, which result from the interaction between the first particle beam and the sample 16. The signals generated by the detector 15 are transmitted to an electronics unit (not illustrated) for generating an image based on signals generated by the detector 15.

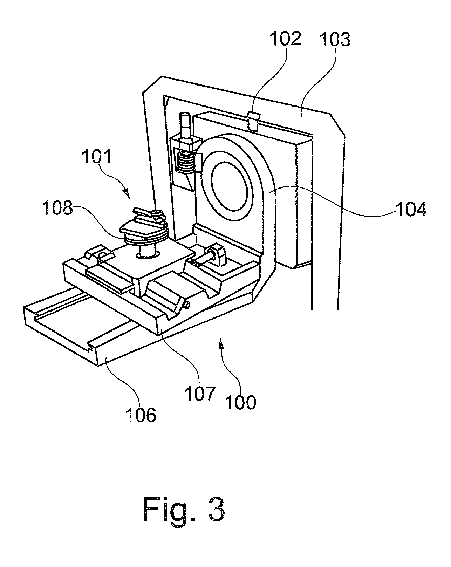

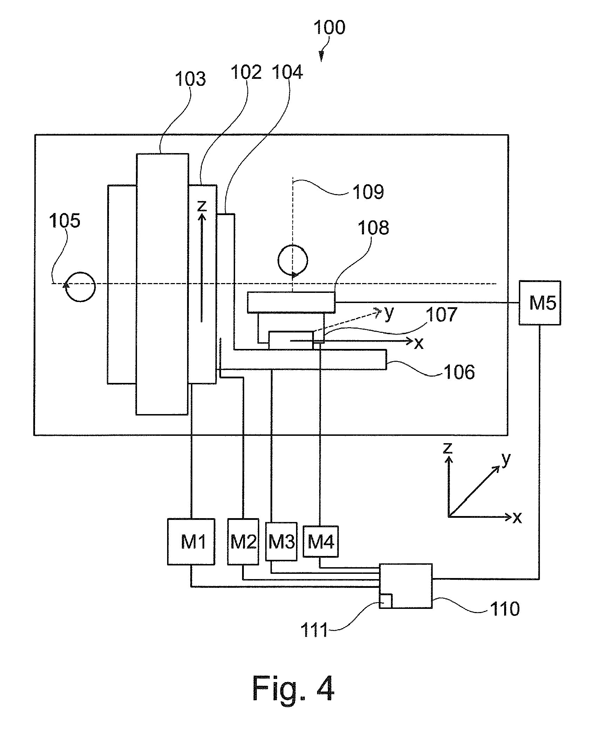

The sample 16 is arranged on a sample receptacle of a carrier element. The carrier element is also known as a sample stage. The sample stage is not illustrated in Figure 2, but it is illustrated in Figures 3 and 4, which will be described further below. Using the sample stage, the sample 16 is arranged such that it can move on three axes which are arranged to be mutually perpendicular (specifically an x-axis, a y-axis and a z-axis). Furthermore, the sample stage can be rotated about two rotation axes which are arranged to be mutually perpendicular. It is therefore possible to move the sample 16 to a desired position.

As mentioned above, reference sign 3 denotes the second charged particle beam column, in the form of an ion beam column. The second charged particle beam column 3 has a second beam generator 27 in the form of an ion source. The second beam generator 27 is used for generating a second particle beam, namely a second charged particle beam, in the form of an ion beam. Furthermore, the second charged particle beam column 3 is provided with an extraction electrode 28 and a collimator 29. The collimator 29 is followed by a variable aperture 30 in the direction of the sample 16 along the second optical axis 5. The second particle beam is focused onto the sample 16 using a second objective lens 31 in the form of focusing lenses. Raster electrodes 32 are provided in order to scan the second particle beam over the sample 16 in the form of a raster.

**Figures 3** **and** **4** show the sample stage 100 in more detail. The sample stage 100 is movable and has a sample receptacle 101, on which the sample 16 is to be arranged. The sample stage 100 has movement elements which ensure a movement of the sample stage 100 in such a way that a region of interest on the sample 16 can be prepared, examined and/or analyzed using a particle beam. The movement elements are illustrated schematically in Figures 3 and 4 and will be explained below.

The sample stage 100 has a first movement element 102 on a housing 103 of the sample chamber 49, in which the sample stage 100 is arranged. The first movement element 102 renders possible a movement of the sample stage 100 along the z-axis (first translation axis). Furthermore, the sample stage 100 comprises a second movement element 104. The second movement element 104 renders possible a rotation of the sample stage 100 about a first rotation axis 105, which is also referred to as tilt-axis. This second movement element 104 serves to tilt the sample 16 arranged in the sample receptacle 101 about the first rotation axis 105.

On the second movement element 104, a third movement element 106 is arranged, the latter being embodied as a guide for a carriage and ensuring that the sample stage 100 can move in the x-direction (second translation axis). The aforementioned carriage is a further movement element, namely a fourth movement element 107. The fourth movement element 107 is embodied in such a way that the sample stage 100 can move in the y-direction (third translation axis). The fourth movement element 107 has a guide guiding a further carriage, on which the sample receptacle 101 is arranged.

The sample receptacle 101 is embodied with a fifth movement element 108, which allows for the sample receptacle 101 to be rotatable about a second rotation axis 109. The second rotation axis 109 is oriented perpendicular to the first rotation axis 105.

As a result of the above-described arrangement, the sample stage 100 of the exemplary embodiment discussed here has the following kinematic chain: first movement element 102 (movement along the z-axis) - second movement element 104 (rotation about the first rotation axis 105) - third movement element 106 (movement along the x-axis) - fourth movement element 107 (movement along the y-axis) - fifth movement element 108 (rotation about the second rotation axis 109).

In a further exemplary embodiment (not illustrated here), further movement elements may be provided such that movements are made possible along further translation axes and/or about further rotation axes.

As is evident from **Figure 4****,** each of the aforementioned movement elements is connected to a drive motor, for example a stepper motor. Thus, the first movement element 102 is connected to a first stepper motor M1 and driven as a result of a driving force provided by the first stepper motor M1. The second movement element 104 is connected to a second stepper motor M2, which drives the second movement element 104. The third movement element 106 is connected to a third stepper motor M3. The third stepper motor M3 provides a driving force for driving the third movement element 106. The fourth movement element 107 is connected to a fourth stepper motor M4, wherein the fourth stepper motor M4 drives the fourth movement element 107. Furthermore, the fifth movement element 108 is connected to a fifth stepper motor M5. The fifth stepper motor M5 provides a driving force, which drives the fifth movement element 108.

The aforementioned stepper motors M1 to M5 are controlled by a control unit 110. The control unit 110 comprises a processor 111, in which a computer program product comprising software is loaded, which - when executed - controls execution of a method explained further below in the particle beam device 1.

It is explicitly noted that the invention is not restricted to the sample stage 100 described here. Rather, the invention can be applied in any embodiment of a movable sample stage and also in any other type of kinematic chain. Furthermore, the motion devices (drive motors) M1 to M5 are not restricted to stepper motors. Rather, any kind of motion equipment such as DC motors or piezo elements, for example, may be used to drive the movement elements.

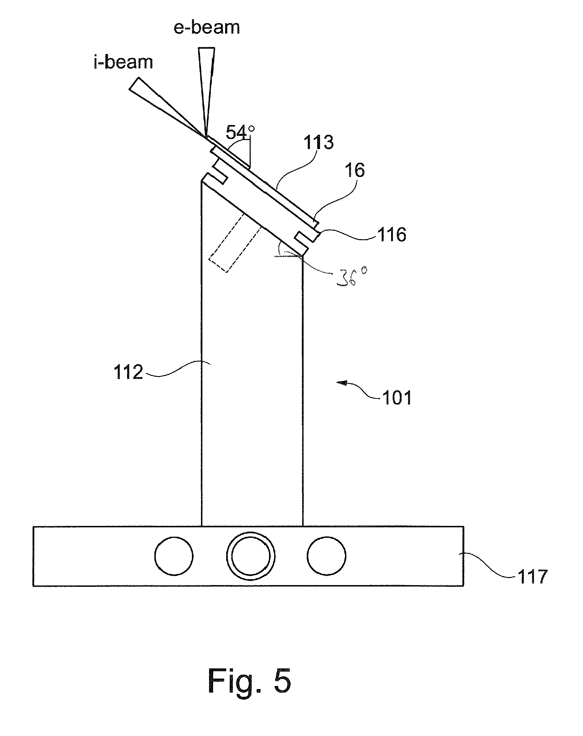

**Figure 5** shows a simplified illustration of an embodiment of the sample receptacle 101 being arranged at the sample stage 100. Like reference signs refer to like elements. **Figure 5** shows the sample receptacle 101 in an origin position in which a base element 117 in form of a plate is oriented parallel to the horizontal, i.e. with a mounting plane of the plate being arranged perpendicular to the first optical axis 4. It is explicitly noted that the invention is not restricted to the sample receptacle 101 having exactly this origin position. Instead, any origin position suitable for the invention is possible.

The sample receptacle 101 shown in **Figure 5** comprises a stub 116 on which the sample 16 is arranged. The stub 116 is arranged at one end of the mounting unit 112 of the sample receptacle 101 in a manner that an upper surface of the stub 116, on which the sample 16 can be mounted, is arranged at an angle of about 36° relative to the mounting plane of the base element 117. The angle between the upper surface of stub 116 and the mounting plane of the base element 117 is selected in a manner that this angle and the angle between the first optical axis 4 and the second optical axis 5 add to about 90°. In this way, the upper surface of the stub 116 is arranged nearly parallel to the second optical axis 5 if concurrently the mounting plane of the base element 117 is arranged perpendicular to the first optical axis 4. The sample 16 comprises a surface 113 which is arranged parallel to the second optical axis 5 of the second charged particle beam column 3.

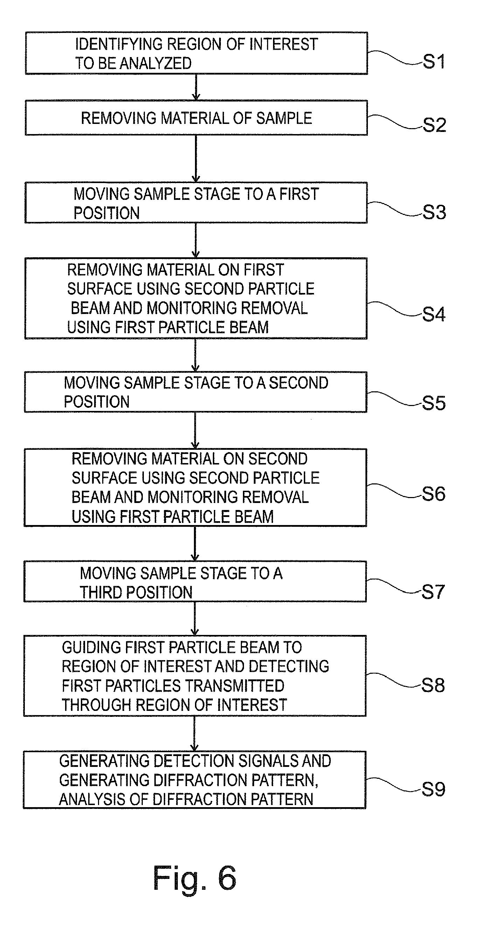

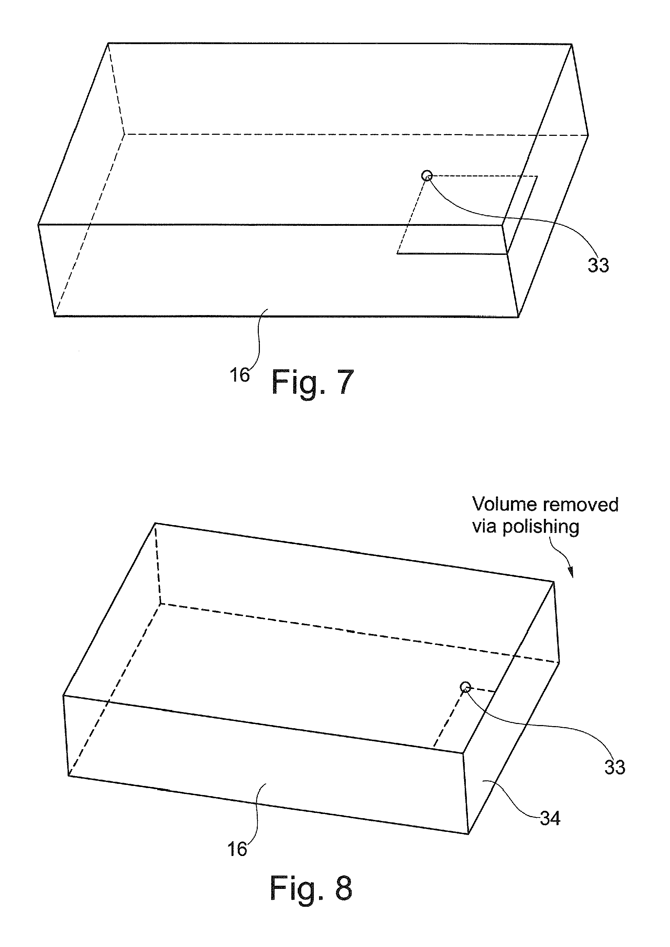

**Figure 6** shows steps of an embodiment of a method according to the invention. The method comprises a step S1. A region of interest 33 to be analyzed of the sample 16 is identified. The method and the device of identifying the region of interest 33 can be suitably chosen. For example, an image of the surface of the sample 16 is generated using the first particle beam. Then, it is possible to identify the region of interest 33 using the generated image. However, the invention is not restricted to the aforementioned way of identifying the region of interest 33. Instead, any kind of identifying the region of interest 33 can be used, for example using an X-ray-beam or a light beam, for example a laser beam. The region of interest 33 can be situated on the surface of the sample 16 or is situated inside the sample 16, as shown in **Figure 7****.**

The method also comprises a step S2. In this step S2, material is removed from the sample 16, wherein a first surface 34 of the sample 16 is generated. Since the sample 16 might be large (for example with dimensions of 100 µm x 5 µm x 20 µm for the width, the height and the depth, respectively, of the sample 16), step S2 provides removing material using mechanical polishing or laser ablation until the first surface 34 is at a distance of about 10 µm to 60 µm from the region of interest 33 (see **Figure 8****).** The aforementioned removal of material may be performed in a different device than the particle beam device 1. After removal of the material, the sample 16 is arranged on the sample receptacle 101. The method is not restricted to the aforementioned ways of removing the material. Instead, any suitable way of removing material can be used in step S2. In particular, the removing of material in step S2 can also be performed in the particle beam device 1 using the second particle beam or by gas assisted etching using the first particle beam or the second particle beam.

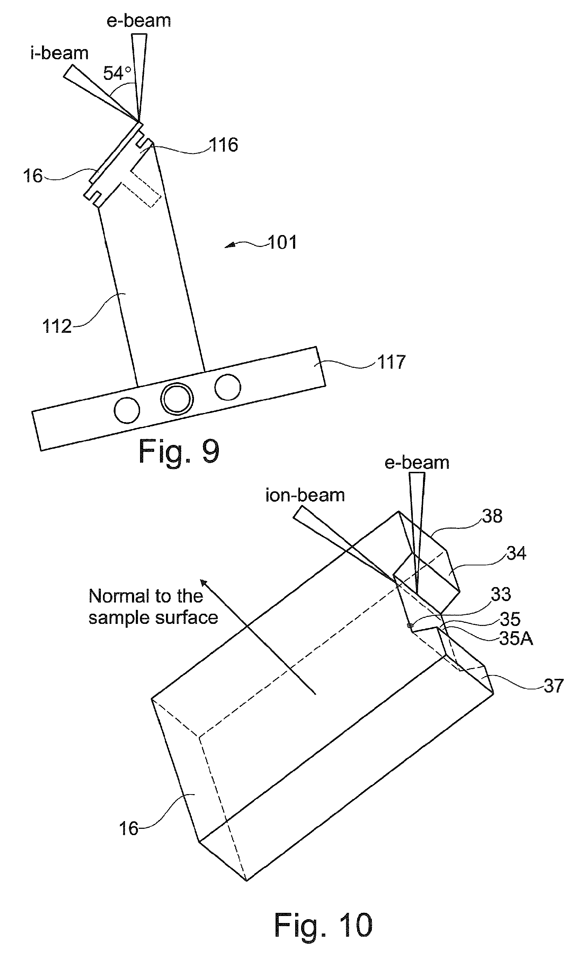

The method also comprises a step S3. In this step S3, the sample stage 100 is moved from the above mentioned origin position to a first position by rotating the sample stage 100 at an angle of 18° around the first rotation axis 105 (tilt axis) and by rotating the sample stage 100 around the second rotation axis 109 at an angle of 180°. **Figure 9** shows the sample receptacle 101 in the first position. In the first position, the second optical axis 5 is parallel or basically parallel to the first surface 34 of the sample 16. The difference of orientation of the second optical axis 5 and the first surface 34 of the sample may be about 2° or 4°. If the second optical axis 5 is parallel or basically parallel to a first surface 34 of the sample 16, the second particle beam impinges on the first surface 34 with grazing incidence.

The method also comprises a step S4. In this step S4, material on the first surface 34 of the sample 16 is removed using the second particle beam, thereby generating a recess having a cross-section with a U-shaped form on the first surface 34, as shown in **Figure 10****.** The U-shaped form comprises a base limb 35A and two side limbs extending from the base limb 35A, namely a first limb 37 and a second limb 38. The base limb 35A comprises a second surface 35. The removal of the material is monitored using the first particle beam and by generating images of the first surface 34 and the second surface 35. After the removal, the region of interest 33 is much closer to the second surface 35 than before the removal.

The method also comprises a step S5. In this step S5, the sample stage 100 is moved from the first position to a second position which, in this exemplary embodiment, corresponds to the origin position of **Figure 5****.** Therefore, the sample stage 100 is moved from the first position back to the origin position by rotating the sample stage 100 at an angle of 18° around the first rotation axis 105 and by rotating the sample stage 100 around the second rotation axis 109 at an angle of 180°. In the second position, the second optical axis 5 is perpendicular to the second surface 35 of the sample 16.

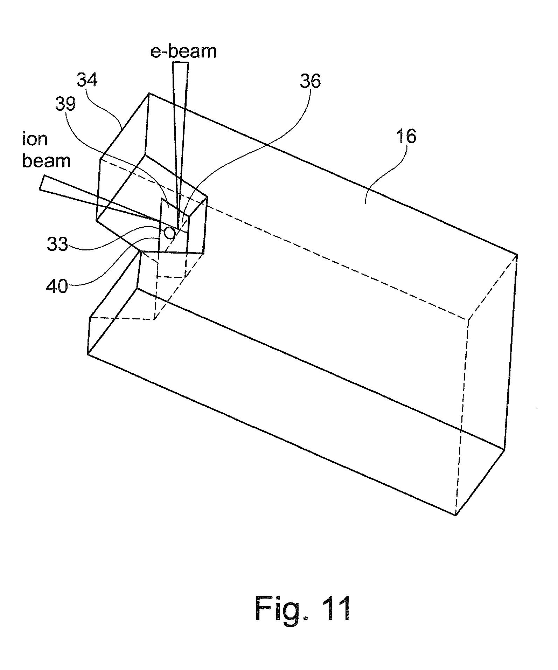

The method also comprises a step S6. In this step S6, material of the second surface 35 and beneath the second surface 35 of the sample 16 is removed using the second particle beam. The removal of the material is monitored using the first particle beam by generating images. When removing the material, a first side 39 of the region of interest 33 and a second side 40 of the region of interest 33 are generated, the first side 39 being arranged opposite the second side 40 (see Figure 11). The region of interest 33 is arranged between the first side 39 and the second side 40. In other words, by removing the material, the region of interest 33 is formed as a lamella 36. The material around the region of interest 33 in the form of the lamella 36 is removed so that the lamella 36 is accessible from several directions. In particular, material above the lamella 36 - which is seen from the first side 39 in the direction of the first beam generator 6 - and below the lamella 36- which is seen from the second side 40 in the direction of the EBSD detector 1000 - is removed. In this manner, the lamella 36 having an upper wall and a lower wall is formed. The lamella 36 includes the region of interest between the upper wall and the lower wall.

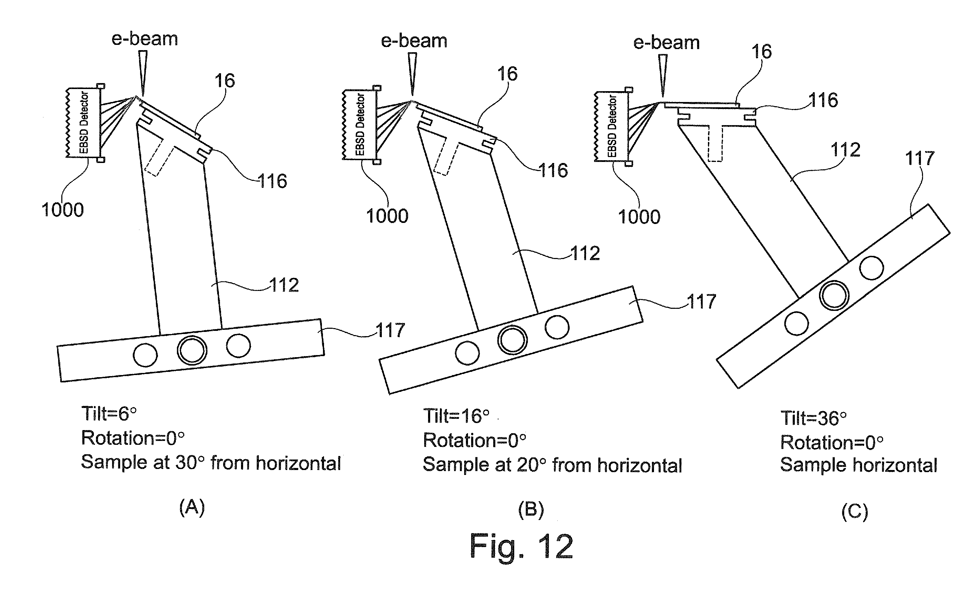

The method also comprises a step S7 (see **Figure 6****).** In this step S7, the sample stage 100 is moved from the second position to a third position. The region of interest 33 of the sample 16 is analyzed in this third position, as explained later below. The third position of the sample stage 100 is chosen with respect to a desired relative position of the region of interest 33 to the first optical axis 4. In particular, the third position of the sample stage 100 is chosen in such a way that the angle between the first side 39 of the region of interest 33 and the first optical axis 4 is in the range of 60° and 90°, wherein the boundaries of this range are included in the range. If the first optical axis 4 is vertically oriented, the first side 39 of the region of interest 33 can be oriented at an angle from 0° to 30° to the horizontal, as shown in **Figures 12A to 12C. Figure 12A** shows an embodiment wherein the sample stage 100 is rotated around the first rotation axis 105 at about 6°. In this position of the sample stage 100, the first side 39 of the region of interest 33 is oriented at an angle of about 30° to the horizontal. **Figure 12B** shows an embodiment wherein the sample stage 100 is rotated around the first rotation axis 105 at about 16°. In this position of the sample stage 100, the first side 39 of the region of interest 33 is oriented at an angle of about 20° to the horizontal. **Figure 12C** shows an embodiment wherein the sample stage 100 is rotated around the first rotation axis 105 at about 36°. In this position of the sample stage 100, the first side 39 of the region of interest 33 is oriented at an angle of 0° to the horizontal. Therefore, the first side 39 is oriented perpendicularly to the first optical axis 4.

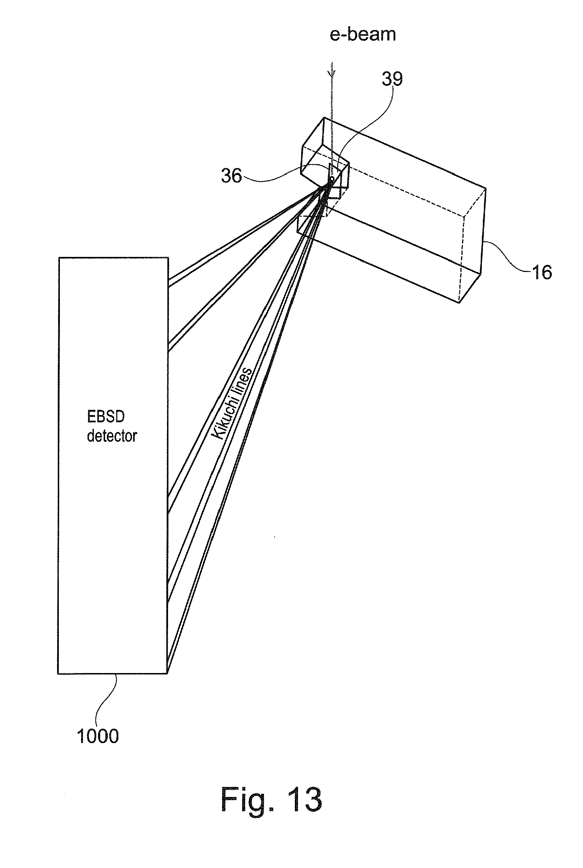

In a further step S8 of the method, the region of interest 33 of the sample 16 is now analyzed (see **Figure 6****).** The first particle beam is guided to the first side 39 of the region of interest 33 (see also **Figure 13****).** The electrons of the first particle beam being transmitted through the region of interest 33 are scattered in different directions depending on the crystallographic orientation of the material in the region of interest 33. The scattered electrons are detected by the EBSD detector 1000. The EBSD detector 1000 generates detector signals which are used to generate a diffraction pattern or diffraction patterns based on the detected scattered electrons. i.e. the scattered first charged particles. For example, the EBSD detector 1000 comprises a CCD chip or a scintillator connected to a CCD Chip with a detection area of about 20 mm x 20 mm or 30 mm x 30 mm. The EBSD detector 1000 enables the generation of an image of the diffraction pattern at the position of the EBSD detector 1000.

The method also comprises a step S9 (see Figure 6). Using the EBSD detector 1000, the diffraction pattern or diffraction patterns are detected by detection of the scattered electrons. The diffraction pattern or the diffraction patterns comprise Kikuchi lines and Kikuchi bands projected from the second side 40 of the region of interest 33, the second side 40 being oriented in the direction of the EBSD detector 1000 (see **Figure 13****).** The diffraction pattern(s) (also called Kikuchi pattern(s)) may be displayed on a screen or monitor and may be analyzed by a analyzing unit of the EBSD detector 1000, thereby providing information about the crystalline structure and crystalline orientation at the impact point (also called impact position) of the focused first particle beam at the region of interest 33. If the first particle beam is scanned over the area of the region of interest 33 (that is the lamella 36), the diffraction pattern(s) may be analyzed at each point of the scanned area. The crystalline data, for example the crystalline orientation, may be calculated at each point of the scanned area and then displayed on the screen or monitor. The displayed data comprises, for example, crystalline orientation contrast images of the scanned area of the region of interest (that is the lamella 36). Furthermore, the crystalline data values of the region of interest may be superimposed or combined with the data of the image obtained by detecting interaction particles and/or interaction radiation using the detector 15.

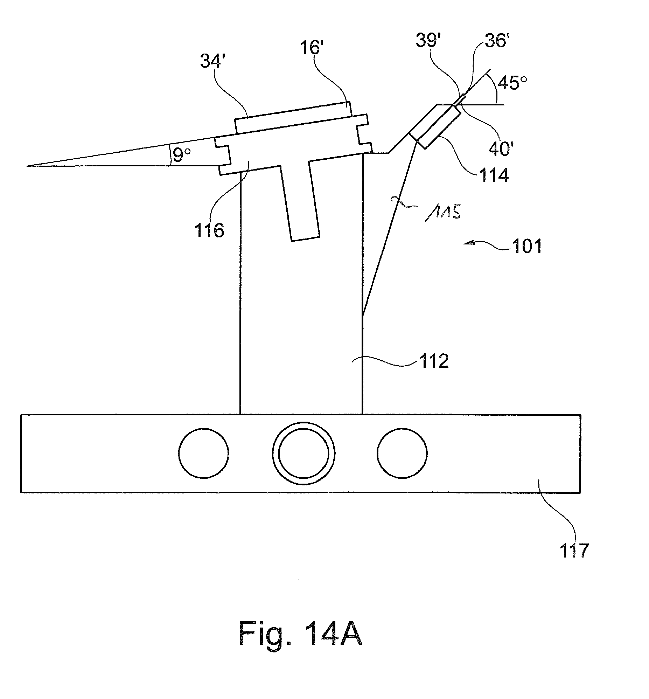

**Figure 14A** shows a simplified illustration of a further embodiment of the sample receptacle 101 according to the invention. Like reference signs refer to like elements. **Figure 14A** shows the sample receptacle 101 in an origin position in which the base element 117 is oriented parallel to the horizontal, i.e. perpendicular to the first optical axis 4. The sample receptacle 101 comprises a first stub and a second stub, wherein the first stub is the stub 116. The stub 116 is arranged at one end of the mounting unit 112 of the sample receptacle 101 in such a way that it is arranged at an angle of about 9° inclined to a mounting plane of the base element 117 so that a surface normal to the upper surface of the stub 116 is inclined at an angle of 9° relative to the first optical axis 4 if a surface normal to the mounting plane of the base element 117 is parallel to the first optical axis 4. The second stub is a lamella holder 114 which is arranged at an extension 115 of the sample receptacle 101. For example, the lamella holder 114 is a holder for a grid, in particular a grid for TEM analysis.

The sample receptacle 101 shown in **Figure 14A** is used in a further embodiment of the method according to the invention, which is similar to the embodiment shown in **Figure 6** and which comprises several identical method steps. In step S1, a region of interest 33 to be analyzed of a sample 16' is identified. Again, the method and the device of identifying the region of interest 33 can be suitably chosen. For example, an image of the surface of the sample 16' is generated using the first particle beam. Using the generated image, it is possible to identify the region of interest 33. The region of interest 33 can be situated on the surface of the sample 16' or is situated inside the sample 16' as shown in **Figure 7****.**

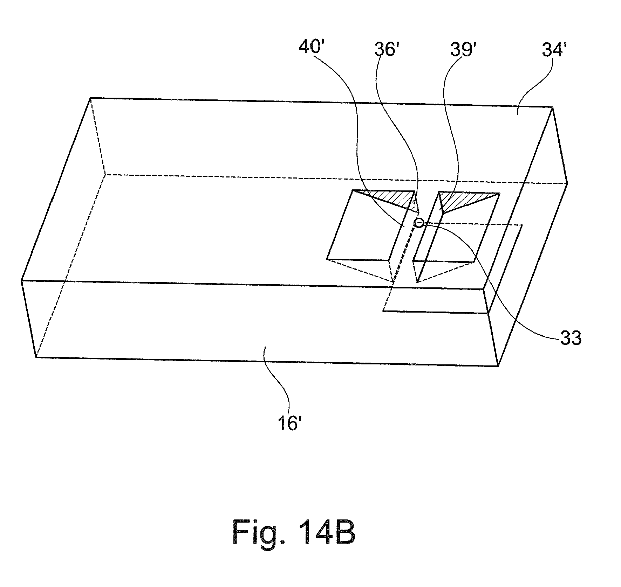

In step S2, material is removed from the sample 16', wherein the first surface 34' of the sample 16' is generated as shown in **Figure 14B****.** The first surface 34' is the top surface of the sample 16', the top surface being orientated in the direction of the first particle beam. Since the sample 16' might be large (see above), step S2 provides removing material using mechanical polishing or laser ablation until the first surface 34' is at a distance of about 10 µm to 60 µm from the region of interest 33. The aforementioned removal of material may be performed in a different device than the particle beam device 1. After removal of the material, the sample 16' is arranged on the stub 116.

If the region of interest 33 of the sample 16' is close to the first surface 34' (for example at a distance of about 10 µm to 60 µm), step S2 of the method may be omitted.

In step S3 of the second embodiment, the sample stage 100 is moved from the origin position shown in **Figure 14A** to a first position by rotating the sample stage 100 at an angle of 45° around the first rotation axis 105. After rotating the sample stage 100, the second optical axis 5 is perpendicular to the first surface 34' of the sample 16'.

In step S4 of the second embodiment, material on the first surface 34' of the sample 16' is removed using the second particle beam, thereby generating a lamella comprising the region of interest 33 as shown in **Figure 14B****.** By removing the material, a first side 39' and a second side 40' of the lamella are generated as also shown in **Figure 14B****.** The first side 39' and the second side 40' are opposite to each other and form side walls of a lamella 36'. The removal of the material and the generating of the lamella 36' are monitored using the first particle beam and by generating images of the first surface 34'.

In step S5 of the second embodiment, the sample stage 100 is moved from the first position to a second position which, in this exemplary embodiment, corresponds to the origin position of **Figure 14A****.** Thus, the sample stage 100 is moved from the first position back to the origin position by rotating the sample stage 100 at an angle of 45° around the first rotation axis 105. In this position, the lamella 36' is fixed to a micromanipulator. After being fixed to the micromanipulator, the lamella 36' is completely cut out of the sample 16'. For example, this is done by undercutting the lamella 36' at a bottom side of the lamella 36' and by cutting of side walls which are still connected to the sample 16' as shown in **Figure 14B****.**

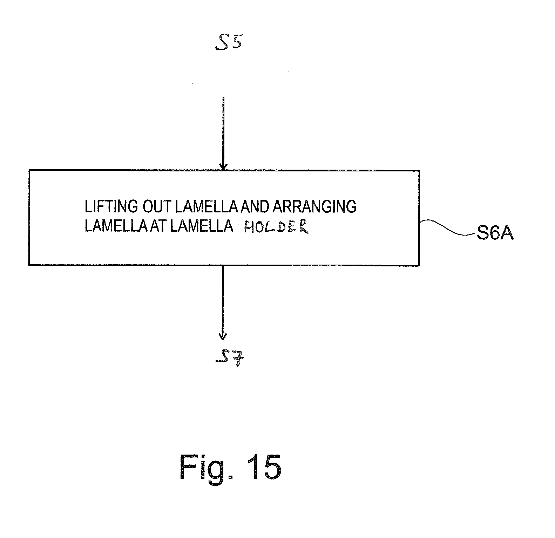

This embodiment of the method according to the invention comprises a step S6A as shown in **Figure 15****.** In step S6A, the lamella 36' including the region of interest 33 is lifted out of the sample 16' and is arranged at the lamella stub 114. The lifting out process is carried out with the micromanipulator, for example. After arranging the lamella 36' at the lamella holder 114, the micromanipulator is cut off from the lamella 36', and the lamella 36' is ready for further method steps.

In step S7, the sample stage 100 is moved from the second position to a third position. Again, the third position of the sample stage 100 is chosen with respect to a desired relative position of the region of interest 33 to the first optical axis 4. In particular, the third position of the sample stage 100 is chosen in such a way that the angle between the first side 39' of the region of interest 33 and the first optical axis 4 is in the range of 60° and 90°, wherein the boundaries of this range are included in the range. If the optical axis 4 is vertically oriented, this means that the first side 39' of the region of interest 33 can be oriented at an angle from 0° to 30° to the horizontal. For example, if the sample stage 100 starting from the second position is rotated around the first rotation axis 105 at about 15° and if the sample stage 100 is rotated around the second rotation axis 109 at about 180°, the first side 39' of the region of interest 33 (the lamella) is oriented at an angle of about 30° to the horizontal. If, for example, the sample stage 100 starting again from the second position is rotated around the first rotation axis 105 at about 45° and if the sample stage 100 is rotated around the second rotation axis 109 at about 180°, the first side 39' of the region of interest 33 (the lamella) is oriented at an angle of about 0° to the horizontal. Thus, the first side 39' is horizontally oriented.

In step 8, the region of interest 33 of the sample 16' is now analyzed with the first charged particle beam impinging at an angle in the range between 0° and 30° to the surface normal to the first side 39'. The first particle beam is guided to the first side 39' of the region of interest 33. The electrons of the first particle beam being transmitted through the region of interest 33 are scattered in different directions depending on the crystallographic orientation of the material in the region of interest 33. The scattered electrons are detected using the EBSD detector 1000. The EBSD detector 1000 generates detector signals which are used to generate a diffraction pattern or diffraction patterns based on the detected scattered electrons. The EBSD detector 1000 enables the generation of an image of the diffraction pattern or diffraction patterns at the position of the EBSD detector 1000.

The method also comprises a step S9 (see **Figure 6****).** Using the EBSD detector 1000, the diffraction pattern or diffraction patterns are detected by detection of the scattered electrons. Again, the diffraction pattern or the diffraction patterns comprise Kikuchi lines and Kikuchi bands projected from the second side 40' of the region of interest 33, the second side 40' being oriented in the direction of the EBSD detector 1000 (see **Figure 13****).** The diffraction pattern(s) (also called Kikuchi pattern(s)) may be displayed on the screen or the monitor and may be analyzed by an analyzing unit of the EBSD detector 1000, thereby providing information about the crystalline structure and crystalline orientation at the impact point (also called impact position) of the focused first particle beam at the region of interest 33. If the first particle beam is scanned over the area of the region of interest 33 (that is the lamella 36'), the diffraction pattern(s) may be analyzed at each point of the scanned area. The crystalline data, for example the crystalline orientation, may be calculated at each point and then displayed on the screen or monitor. The displayed data comprises, for example, crystalline orientation and/or contrast images of the scanned area of the region of interest (that is the lamella 36').

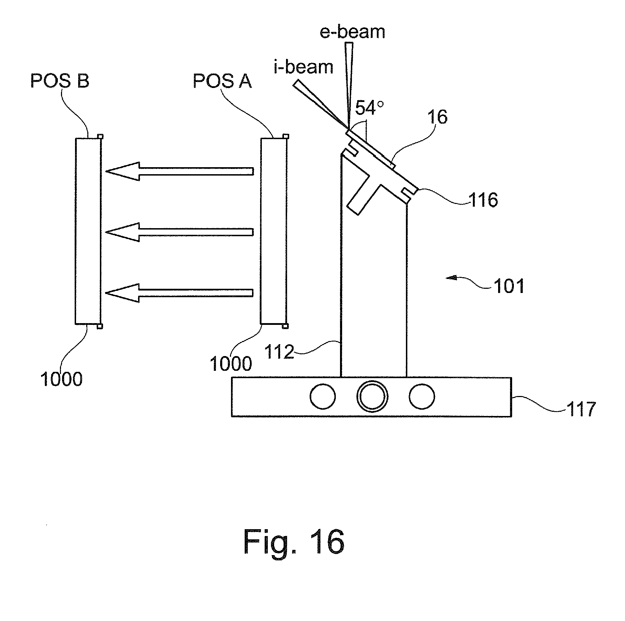

**Figure 16** is based on **Figure 12A****.** Like reference signs refer to like elements. **Figure 16** shows an embodiment of the invention comprising two positions of the EBSD detector 1000, namely a first position POS A and a second position POS B. The EBSD detector 1000 may be positioned from the first position POS A into the second position POS B and vice versa by a moving unit (not shown) moving the EBDS detector 1000. The moving unit may be an electrical and/or mechanical moving unit. The EBSD detector 1000 is positioned in the first position POS A when detecting scattered electrons and generating diffraction patterns, as explained above. However, when the sample 16 is prepared, in particular when material of the sample 16 is removed, the EBSD detector 1000 is positioned in the second position POS B in order to avoid damaging the EBSD detector 1000 during movement of the sample stage 100 and/or deposition of material removed from the sample 16 on the EBSD detector 1000. The EBSD detector 1000 may be in addition in the second position POS B protected or covered by a protective shield (not shown in **Figure 16****)** to avoid deposition or contamination of the surface of the EBSD detector 1000. The embodiment shown in **Figure 16** may be used for all embodiments of the methods of the invention.

Each feature mentioned in the description and/or disclosed in the drawings and/or in the claims may be essential to the invention as a single feature or as a combination of features. The invention is not restricted to the embodiments disclosed in the application. The invention may be varied with respect to the claims and drawings on the knowledge of a person skilled in the art.

### List of reference signs

- 1: particle beam device
- 2: first charged particle beam column (electron beam column)
- 3: second charged particle beam column (ion beam column)
- 4: first optical axis
- 5: second optical axis
- 6: first beam generator
- 7: first electrode
- 8: second electrode
- 9: third electrode
- 10: beam guide tube
- 11: collimator arrangement
- 12: first annular coil
- 13: yoke
- 14: pinhole diaphragm
- 15: detector
- 16, 16': sample
- 17: central opening
- 18: first objective lens
- 19: magnetic lens
- 20: electrostatic lens
- 21: second annular coil
- 22: inner pole piece
- 23: outer pole piece
- 24: end of beam guide tube
- 25: terminating electrode
- 26: raster device
- 27: second beam generator
- 28: extraction electrode
- 29: collimator
- 30: variable aperture
- 31: second objective lens
- 32: raster electrodes
- 33: region of interest
- 34, 34': first surface
- 35: second surface
- 35A: base limb
- 36, 36': lamella
- 37: first limb
- 38: second limb
- 39, 39': first side
- 40, 40': second side

- 49: sample chamber

- 100: sample stage
- 101: sample receptacle
- 102: first movement element
- 103: housing
- 104: second movement element
- 105: first rotation axis
- 106: third movement element
- 107: fourth movement element
- 108: fifth movement element
- 109: second rotation axis
- 110: control unit
- 111: processor
- 112: mounting unit
- 113: surface of sample
- 114: lamella holder
- 115: extension
- 116: stub
- 117: base element
- 1000: EBSD detector

- M1: first stepper motor
- M2: second stepper motor
- M3: third stepper motor
- M4: fourth stepper motor
- M5: fifth stepper motor
- S1 to S9: method steps

- POS A: first position of EBSD detector
- POS B: second position of EBSD detector

## Claims

1. Method for preparing and analyzing an object (16) comprising a region of interest (33) to be analyzed, wherein the method is carried out using a particle beam device (1), wherein
- the particle beam device (1) comprises at least one first particle beam column (2) having a first optical axis (4) and at least one second particle beam column (3) having a second optical axis (5),
- the first particle beam column (2) comprises at least one first particle beam generator (6) for generating a first particle beam having first charged particles and at least one first objective lens (18) for focusing the first particle beam onto the object (16),
- the second particle beam column (3) comprises at least one second particle beam generator (27) for generating a second particle beam having second charged particles and at least one second objective lens (31) for focusing the second particle beam onto the object (16),
- the object (16) is arranged on a carrier element (100), wherein the carrier element (100) is movable in three spatial directions (x, y, z) oriented perpendicular to one another and wherein the carrier element (100) is rotatable around a first rotation axis (105) and around a second rotation axis (109) being oriented perpendicular to the first rotation axis (105),
- the particle beam device (1) comprises a first detector (1000) for detecting first charged particles being transmitted through the object (16), and wherein
- the particle beam device (1) comprises a second detector (15) for detecting interaction particles and/or interaction radiation generated when the first particle beam impinges on the object (16),
wherein the method comprises the following steps:
a) moving the carrier element (100) to a first position such that the second optical axis (5) is parallel to a first surface (34) of the object (16),
b) removing material from the first surface (34) of the object (16) using the second particle beam and monitoring the first surface (34) of the object (16) using the first particle beam and using the second detector (15), wherein a second surface (35) of the object (16) is generated when the material is removed from the first surface (34) of the object (16),
c) moving the carrier element (100) to a second position such that the second optical axis (5) is perpendicular to the second surface (35) of the object (16),
d) removing material from the second surface (35) of the object (16) using the second particle beam and monitoring the step of removing the material from the object (16) using the first particle beam and using the second detector (15), wherein the step of removing the material generates a first side (39) of the region of interest (33) and a second side (40) of the region of interest (33), wherein the first side (39) is arranged opposite the second side (40) and wherein the region of interest (33) to be analyzed is arranged between the first side (39) and the second side (40),
e) moving the carrier element (100) to a third position such that the first optical axis (4) and the first side (39) of the region of interest (33) are oriented at an angle to one another, wherein the angle is in the range of 60° to 90°,
f) guiding the first particle beam to the first side (39) of the region of interest (33),
g) detecting the first charged particles being transmitted through the region of interest (33) using the first detector (1000),
h) generating detection signals using the detected first charged particles and acquiring at least one diffraction pattern of the region of interest, and
i) analyzing the region of interest (33) using the diffraction pattern.

2. Method according to claim 1, wherein the method further comprises:
- acquiring a crystalline data value depending on a crystalline structure of the region of interest (33),
- displaying the crystalline data value on a screen, and
- displaying an image of the region of interest (33) on the screen.

3. Method according to claim 1 or 2, wherein the method further comprises identifying the region of interest (33) using the first particle beam.

4. Method according to one of the preceding claims, wherein
- the first side (39) of the region of interest (33) and the second side (40) of the region of interest (33) are oriented parallel to one another and/or wherein the first side (39) of the region of interest (33) and the second side (40) of the region of interest (33) are oriented perpendicular to the second surface (35) of the object (16),
wherein the step of removing material from the second surface (34', 35) comprises removing the material such that the region of interest (33) has a distance of 40 nm to 300 nm or of 70 nm to 100 nm from the first side (39) to the second side (40).

5. Method according to one of the preceding claims, wherein the step of removing material from the first surface (34) of the object (16) using the second particle beam comprises generating a U-shaped form on the first surface (34) .

6. Method according to one of the preceding claims, wherein the first particle beam is an electron beam and wherein the method comprises at least one of the following:
- the step of monitoring the first surface (34) of the object (16) comprises using the electron beam, or
- the step of monitoring the second surface (35) of the object (16) comprises using the electron beam.

7. Method according to one of the preceding claims, wherein the second particle beam is an ion beam and wherein the method comprises at least one of the following:
- the step of removing material from the first surface (34) of the object (16) comprises using the ion beam; or
- the step of removing material from the second surface (35) of the object (16) comprises using the ion beam.

8. Method according to one of the preceding claims, wherein the method comprises at least one of the following:
- the step of moving the carrier element (100) to the first position comprises rotating the carrier element (100) around the first rotation axis (105) at an angle between 10° and 20° or between 12° and 18°; or
- the step of moving the carrier element (100) to the second position comprises rotating the carrier element (100) around the second rotation axis (109) at an angle between 160° and 200° or between 170° and 180°, and the step of moving the carrier element (100) comprises rotating the carrier element (100) around the first rotation axis (105) at an angle between 10° and 20° or between 12° and 18°; or
- the step of moving the carrier element (100) to the third position comprises rotating the carrier element (100) around the first rotation axis (105) at an angle between 4° and 40° or at an angle between 6° and 36°.

9. Method according to one of the preceding claims, wherein the method comprises the following steps:
- moving the first detector (1000) to a first position (POS A) for detecting first charged particles being transmitted through the object (16); and
- moving the first detector (1000) to a second position (POS B) when removing material from the first surface (34, 34') or the second surface 35 of the object (16).

10. Method according to one of the preceding claims, wherein the method is carried out within a vacuum chamber (49) of the particle beam device (1) and wherein the steps d) to i) are performed while maintaining the object (16) within the vacuum chamber (49).

11. Method for preparing and analyzing an object (16) comprising a region of interest (33) to be analyzed, wherein the method is carried out using a particle beam device (1), wherein the method comprises the following steps:
a) moving a carrier element (100) to a first position such that a second optical axis (5) is parallel to a first surface (34) of the object (16),
b) removing material from a first surface (34) of the object (16) using a second particle beam and monitoring the first surface (34) of the object (16) using a first particle beam and using a second detector (15), wherein a second surface (35) of the object (16) is generated when the material is removed from the first surface (34) of the object (16),
c) moving the carrier element (100) to a second position such that the second optical axis (5) is perpendicular to the second surface (35) of the object (16),
d) removing material from the second surface (35) of the object (16) using the second particle beam and monitoring the step of removing the material from the object (16) using the first particle beam and using the second detector (15), wherein the step of removing the material generates a first side (39) of the region of interest (33) and a second side (40) of the region of interest (33), wherein the first side (39) is arranged opposite the second side (40) and wherein the region of interest (33) to be analyzed is arranged between the first side (39) and the second side (40),
e) moving the carrier element (100) to a third position such that a first optical axis (4) and the first side (39) of the region of interest (33) are oriented at an angle to one another, wherein the angle is in the range of 60° to 90°,
f) guiding the first particle beam to the first side (39) of the region of interest (33),
g) detecting first charged particles of the first particle beam being transmitted through the region of interest (33) using a first detector (1000),
h) generating detection signals using the detected first charged particles and acquiring at least one diffraction pattern of the region of interest, and
i) analyzing the region of interest (33) using the diffraction pattern.

12. Computer program product to be loaded into a processor (111) of a particle beam device (1), wherein the computer program product comprises software for controlling the particle beam device (1) in such a way that the particle beam device (1) performs a method according to one of the preceding claims.

13. Particle beam device (1) for analyzing an object (16) comprising a region of interest (33), wherein the particle beam device (1) comprises
- at least one first particle beam column (2), wherein the first particle beam column (2) comprises a first optical axis (4), at least one first particle beam generator (6) for generating a first particle beam having first charged particles and at least one first objective lens (18) for focusing the first particle beam onto the object (16),
- at least one second particle beam column (3), wherein the second particle beam column (3) comprises a second optical axis (5), at least one second particle beam generator (27) for generating a second particle beam having second charged particles and at least one second objective lens (31) for focusing the second particle beam onto the object (16),
- a carrier element (100) on which the object (16) is to be arranged, wherein the carrier element (100) is movable in three spatial directions (x, y, z) oriented perpendicular to one another and wherein the carrier element (100) is rotatable around a first rotation axis (105) and around a second rotation axis (109) being oriented perpendicular to the first rotation axis (105),
- a first detector (1000) for detecting first charged particles being transmitted through the object (16), and
- a second detector (15) for detecting interaction particles and/or interaction radiation being generated when the first particle beam impinges on the object (16), and
- a control unit (110) comprising a processor (111), wherein a computer program product according to claim 12 is loaded into the processor (111).
